Europäisches Patentamt

European Patent Office

Office européen des brevets

(19)

(11) Publication number: **0 169 598**

**B1**

(12)    EUROPEAN PATENT SPECIFICATION

(45) Date of publication of patent specification: **21.09.88**

(51) Int. Cl.⁴: **H 05 K 9/00**

(21) Application number: **85201069.3**

(22) Date of filing: **03.07.85**

(54) Ventilation panel for electromagnetic shielding.

(30) Priority: **13.07.84 NL 8402224**

(43) Date of publication of application:
**29.01.86 Bulletin 86/05**

(45) Publication of the grant of the patent:
**21.09.88 Bulletin 88/38**

(84) Designated Contracting States:
**DE FR GB IT NL SE**

(56) References cited:
**DE-A-1 591 084**
**US-A-3 253 082**
**US-A-3 584 134**
**US-A-3 821 463**

(73) Proprietor: **N.V. Philips' Gloeilampenfabrieken**
**Groenewoudseweg 1**
**NL-5621 BA Eindhoven (NL)**

(72) Inventor: **Veerman, Frederik Wilhelm Johan**
**c/o INT. OCTROOIBUREAU B.V. Prof. Holstlaan 6**
**NL-5656 AA Eindhoven (NL)**
Inventor: **Jonker, Jan Hilco**
**c/o INT. OCTROOIBUREAU B.V. Prof. Holstlaan 6**
**NL-5656 AA Eindhoven (NL)**

(74) Representative: **Cuppens, Hubertus Martinus**
**Maria et al**
**INTERNATIONAAL OCTROOIBUREAU B.V. Prof.**
**Holstlaan 6**
**NL-5656 AA Eindhoven (NL)**

Courier Press, Leamington Spa, England.

EP 0 169 598 B1

### Description

The invention relates to a ventilation panel comprising a rectangular grating for serving as a shield against electromagnetic radiation, which grating is arranged in a right-angled frame and composed of cells.

Such a grating is known from US—PS—3,821,463. This grating may be made, for example, of aluminium strips absorbing electromagnetic radiation. According to pages 95 and 96 of a catalogue published by the "Metex Electronic Shielding Group" (entitled: "EMI/RFI Shielding Handbook and Catalgoue") in 1977, such a grating can be clamped in a frame having a U-shaped cross-section so that a unit serving as a ventilation panel is obtained. For this purpose, the frame is provided, with, for example, projections which penetrate into the material of the grating. The panel thus formed can then be secured by means of screws extending through the frame and the grating on a wall of a device (box) which has to be electromagnetically shielded whilst maintaining the cooling by natural convection of the heat-producing electrical components present in the box. Between a wall of the box and the ventilation panel there is clamped a further electro-magnetic shield.

A disadvantage of the known ventilation panel is that tolerances of the U-shaped frame and the grating in a direction at right angles to the plane of the grating have to be neutralized by a considerable elastic deformation of the limbs of the comparatively rigid U-shaped frame, whilst plastic deformation of the cellular structure has to ensure that a sufficiently large pressure force is obtained between the frame and the grating. The frame and the grating are consequently subjected to a comparatively high mechanical load.

The invention has for its object to provide a ventilation panel in which the above disadvantage is avoided.

A ventilation panel according to the invention is characterized in that the grating is clamped at at least two opposite sides between a flange of the frame, which is of L-shaped cross-section, and resilient supporting lugs formed on a denticulate mounting element or elements secured to the frame.

Due to the resilient supporting lugs, the ventilation panel has in a direction at right angles to the plane of the grating a comparatively low sensitivity to tolerances of the frame and the grating. The resilience of the supporting lugs is sufficient to neutralize deviations in the dimensions of the frame and the grating.

An embodiment of the ventilation panel which can be mass-produced in a simple and inexpensive manner is characterized in that there is a single mounting element which is formed from one strip of metal by stamping and bending operations.

A preferred embodiment of the ventilation panel is characterized in that the supporting lugs of the or each mounting element have a V-shaped cross-section with a limb which engages the frame and whose height is larger than the height of the relevant flange of the L-section frame to which the mounting element or elements is or are secured.

Due to the fact that the mounting spring extends beyond the flange of the L-section frame which is at right angles to the plane of the grating, the mounting element or elements serve or serves at the same time as an electromagnetic shield at the separation surface between the ventilation panel and the side wall of a box on which the ventilation panel is secured.

A still further embodiment of the ventilation panel is characterized in that the or each mounting element is provided with lugs which are secured to a wall of an electromagnetically shielded box.

Since these lugs can be stamped simultaneously with the supporting lugs from a metal strip, the ventilation panel can be secured without additional components and operations being required.

The invention will be described more fully with reference to the drawings, in which:

Figure 1 is a plan view of a ventilation panel secured on a box,

Figure 2 is a sectional view taken on the line II—II in Figure 1,

Figure 3 is a side elevation locking in the direction of the arrow III in Figure 1,

Figure 4 is a side elevation of the ventilation panel locking in the direction of the arrow IV in Figure 1,

Figure 5 is a side elevation locking in the direction of the arrow V in Figure 1,

Figure 6 is a sectional view taken on the line VI—VI in Figure 1,

Figure 7 is a sectional view taken on the line VII—VII in Figure 1, and

Figure 8 is a perspective view of a box on which the ventilation panel is to be secured.

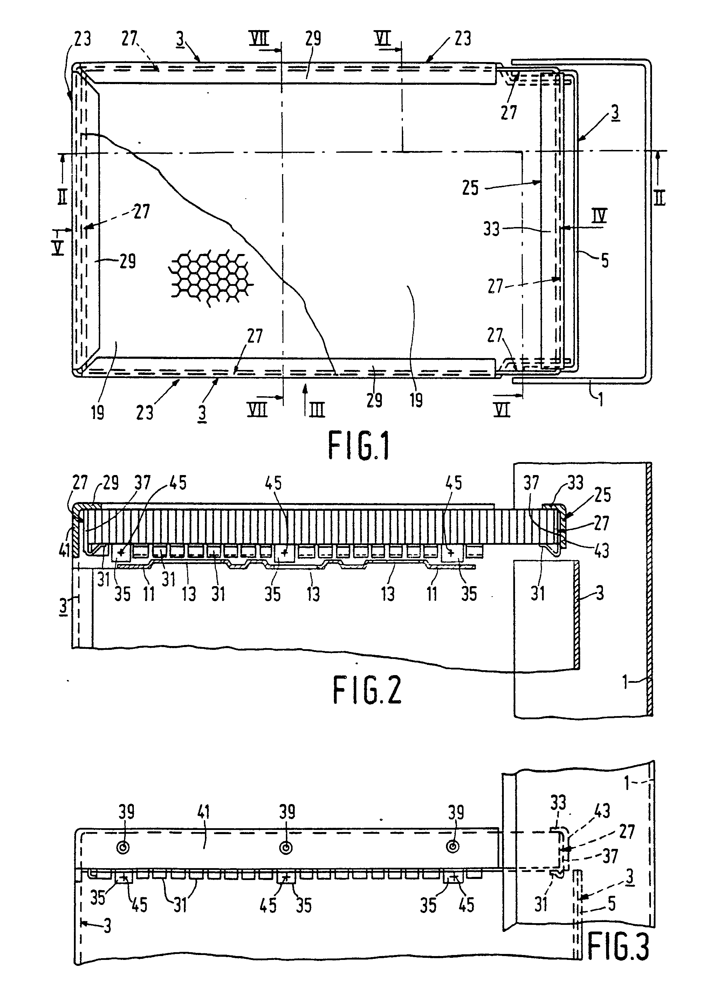

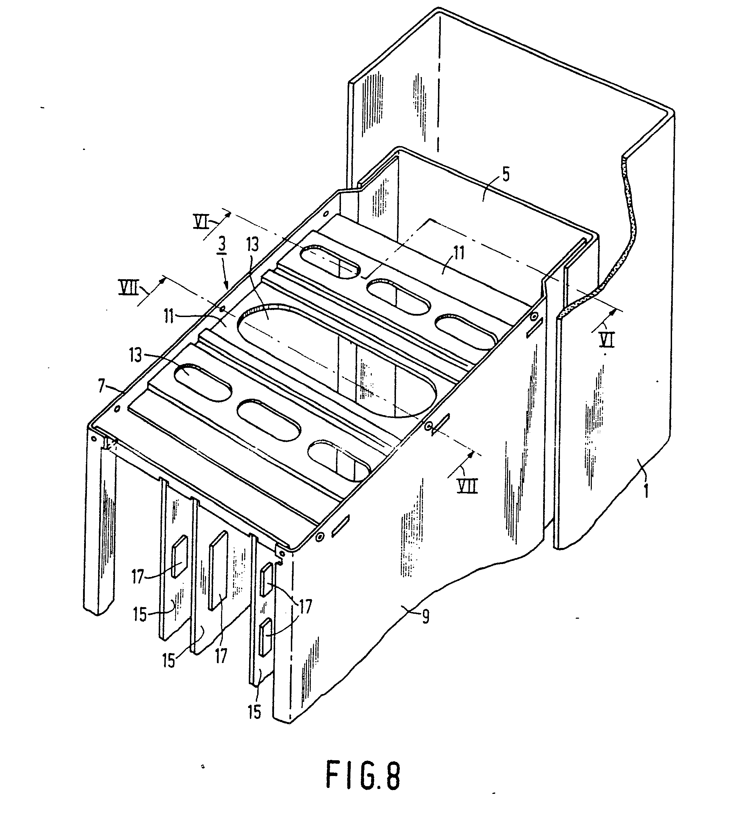

The device illustrated in Figures 1, 2, 3 and 8 comprises a vertical metal column 1 of U-shaped cross-section, in which a box 3 is secured in any convenient manner, which need not be described. The box 3 has a metal back wall 5 of U-shaped cross-section, to which two parallel metal side walls 7 and 9 are secured. At its upper side the box 3 is bounded by a metal plate 11 having ventilation openings 13. The plate 11 forms a connection between the side walls 7 and 9. At its lower side the box 3 is bounded by a metal plate (not shown) similar to the plate 11. Vertically disposed panels 15 carrying heat-producing electrical components 17 are arranged in the box 3. Cooling by natural convection prevents the components 17 from being subjected to an excessively high temperature. A number of juxtaposed boxes 3 can be secured to the vertical column 1. The box 3 and the column 1 together constitute a rack. Such racks are used especially in data-processing apparatus, such as are frequently employed in public telephone exchanges, for example.

Boxes containing electrical components which have to be cooled are usually shielded by means of gratings of the kind described in, for example, US—PS 3,821,463. Such gratings inhibit electromagnetic interference from the inside and from the outside whilst permitting ventilation of the box. In the present case, a rectangular grating 19 with cells 21 formed by aluminium strips (see Figure 1) is arranged above the plate 11 in a right-angled V-shaped metal frame 23 of L-shaped cross-section. A metal connecting bar 25 of L-shaped cross-section is secured across the open end of the frame 23 by means of a mounting element 27 which has a denticulate construction. The grating 19 is clamped between a flange 29 of the frame 23 and resilient denticular supporting lugs 31 on the mounting element 27 and between a flange 33 of the connecting bar 25 and further resilient denticular supporting lugs 31 on the mounting element 27. The latter is constructed as a rectangular frame and is formed by stamping from one strip of metal and subsequent bending through a right angle four times, after which the two ends of the strip are connected riveting them to the connecting bar 25. The supporting lugs 31 are stamped on the metal strip of the mounting element 27, each lug being subsequently bent up into the shape of a V. Securing lugs 35 are also stamped on the strip. The flat strip portion 37 of the mounting element 27 is secured at three sides by means of rivets 39 to a flange 41 of the frame 23. The flanges 29 and 41 of the frame 23 are arranged at right angles to each other to form the L-shaped cross-section of the frame. The strip portion 37 of the mounting element 27 is also secured to a flange 43 of the connecting bar 25. The flanges 33 and 43 of the connecting bar 25 are arranged at right angles to each other to form the L-shaped cross-section of the bar. By means of rivets (not shown), the strip portion 37 of the mounting element 27 is secured to the flange 43 of the connecting bar 25.

Although in Figure 2 the strip portion 37 of the mounting element 27 at the left-hand side of the ventilation panel is shown located at a certain distance from the flange 41 of the frame 23, this is not necessary. An advantage is that any wall portions of the box 3 can be inserted into the gap thus formed. However, the flange 41 may also be secured to the strip portion 37 of the mounting element without a gap by means of rivets.

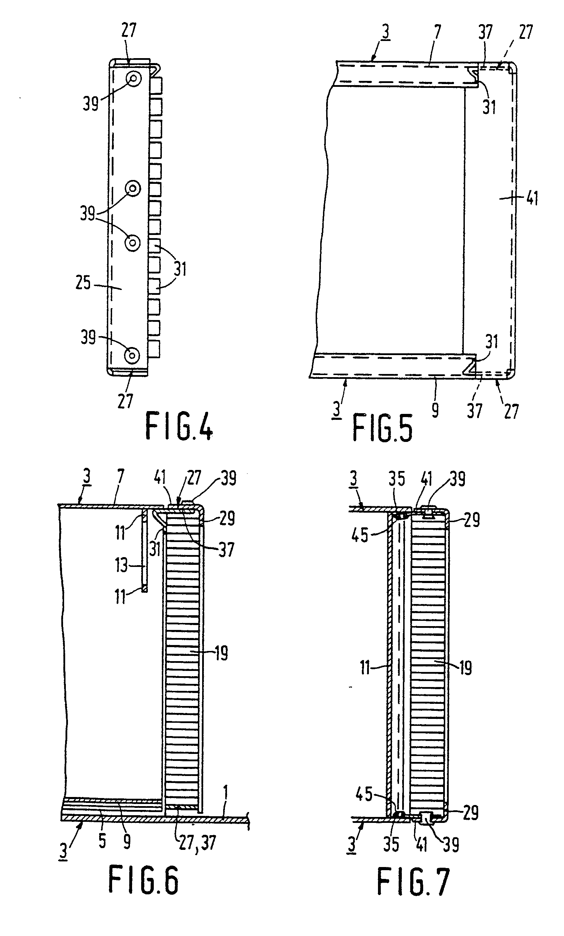

It can be seen from Figures 2, 3, 4, 5 and 6 that the supporting lugs 31 project below the lower face of the grating 19. As a result, the ventilation panel can be resiliently clamped between the walls 7 and 9 of the box 3 (see Figure 5) at two opposite sides of the panel and extends beyond the separation between the ventilation panel and the side walls 7 and 9. The gaps between the supporting lugs 31 of the denticulate mounting element 27 are so dimensioned that electromagnetic radiation cannot enter or emanate, and the mounting element 27 therefore also serves as an electromagnetic shield (by contacting). The mounting element 27 therefore has a threefold function, namely, a mounting function for the grating 19, a mounting function for the complete ventilation panel by resilient clamping between the side walls 7 and 9 of the box 3 and finally, as stated, a shielding function. The securing lugs 35 also are resiliently clamped between the walls 7 and 9 of the box 3. As can be seen from Figure 7, the securing lugs 35 can be provided with apertures 45. If the side walls 7 and 9 also are provided with apertures which coincide with the apertures 45, the securing lugs 35 can be secured to the side walls 7 and 9 by means of screw connections (shown diagrammatically in Figures 2 and 3).

Strictly speaking, the mounting element 27 need be secured to the frame 23 on only two opposite sides. The complete ventilation panel need be resiliently clamped on only two opposite sides between two walls of a box. The remaining gaps can be electromagnetically shielded with a shielding material known *per se*. Instead of the U-shaped frame 23, which is secured to the connecting bar 25 by means of the mounting element 27, a rectangular frame may be used, in which case the separate connecting bar 25 is dispensed with. Instead of the single mounting element 27 in the form of a rectangular frame, it is possible to use four separate denticulate mounting elements arranged one at each side of the grating 19. In that case a stamped strip of metal is not bent through a right angle four times. The mounting elements may be formed from one stamped strip of metal, which is divided into four separation mounting elements by three cutting operations. The complete ventilation panel may be resiliently clamped between a front wall and a back wall of the box instead of between two opposite side walls of the box. In that case, the box must have a front and a back wall or wall portion with an overlap extending above the level of the plate 11.

In the present embodiment, the grating 19 comprises one layer. The dimensions of the cells in the grating 19, especially the ratio between the distance between the opposite walls of each cell (hexagonal cell) and the height of the cell, are chosen so that sufficient electromagnetic shielding is obtained whilst maintaining sufficient ventilation. However, it is also possible to use a grating comprising two layers, as described in US—PS 3,821,463. The material chosen for the grating may be, for example, aluminium, steel or a copper alloy, such as bronze.

Due to the resilient action of the mounting element 27 both in a direction parallel to the plane of the grating 19 and in a direction at right angles to this the construction of the box 3 and the ventilation panel has a comparatively low sensitivity to deviations in dimensions, as a result of which the manufacture can be carried out at low cost. In general, deviations in dimensions of constructions of the kind described give rise to a serious problem because of the comparatively large dimensions of the boxes and ventilation panels. The invention has considerably reduced the problems resulting therefrom.

## Claims

1. A ventilation panel comprising a rectangular grating (19) for serving as a shield against electromagnetic radiation, which grating is arranged in a right-angled frame (23) and is composed of cells, characterized in that the grating is clamped resiliently at at least two opposite sides between a flange (29) of the frame, which is of L-shaped cross-section, and resilient supporting lugs (31) formed on a denticulate mounting element (27) or elements secured to the frame.

2. A ventilation panel as claimed in Claim 1, characterized in that there is a single mounting (27) element which is formed from one strip of metal by stamping and bending operations.

3. A ventilation panel as claimed in Claim 1, characterized in that the supporting lugs (31) of the or each mounting element have a V-shaped cross-section with a limb (37) which engages the frame and whose height is larger than the height of the relevant flange (41) of the L-section frame to which the mounting element or elements is or are secured.

4. A ventilation panel as claimed in Claim 1, characterized in that the or each mounting element is provided with lugs (35) by means of which the mounting element or elements can be secured to a wall or walls of an electromagnetically shielded box.

5. A ventilation panel as claimed in Claim 1, characterized in that the mounting element or elements (27) is or are resiliently clamped on at least two opposite sides of the frame between two walls (7, 9) of an electromagnetically shielded box (3) having ventilation openings for cooling panels which carry electrical components and are secured in the box.

## Patentansprüche

1. Lüftungsplatte mit einem rechteckigen Gitter (19) als Abschirmung gegen elektromagnetische Strahlung, wobei das Gitter in einem rechteckigen Rahmen (23) angeordnet ist und aus Zellen besteht, dadurch gekennzeichnet, dass das Gitter an wenigstens zwei einander gegenüberliegenden Seiten zwischen einem Flansch (29) des Rahmens federnd eingeklemmt ist, wobei der Rahmen einen L-förmigen Querschnitt hat und federnde Tragzungen (31) auf einem gezehnten Montageelement (27) oder Elementen gebildet sind, das bzw. die am Rahmen befestigt sind.

2. Lüftungsplatte nach Anspruch 1, dadurch gekennzeichnet, dass ein einziges Montageelement (27) vorgesehen ist, das aus einem Metallstreifen durch Press- und Biegeoperationen hergestellt wird.

3. Lüftungsplatte nach Anspruch 1, dadurch gekennzeichnet, dass die Tragzungen (31) des oder jedes Montageelements einen V-förmigen Querschnitt mit einem in den Rahmen greifenden Bein (37) haben und deren Höhe grösser als die Höhe des betreffenden Flansches (41) des L-förmigen Rahmens ist, an dem das Montageelement oder die Montageelemente befestigt ist bzw. sind.

4. Lüftungsplatte nach Anspruch 1, dadurch gekennzeichnet, dass das oder jedes Montageelement mit Zungen (35) versehen ist, mit denen das Montageelement oder die Elemente an einer Wand oder an Wände eines elektromagnetisch abgeschirmten Gehäuses befestigt werden kann bzw. können.

5. Lüftungsplatte nach Anspruch 1, dadurch gekennzeichnet, dass das Montageelement oder die Elemente (27) federnd an wenigstens zwei einander gegenüberliegenden Seiten des Rahmens zwischen den beiden Wänden (7, 9) eines elektromagnetisch abgeschirmten Gehäuses (3) eingeklemmt sind, das Lüftungsöffnungen für Kühlplatten enthält, die elektrische Bauteile tragen und im Gehäuse befestigt sind.

## Revendications

1. Panneau de ventilation comprenant une grille rectangulaire (19) destinée à servir de blindage contre le rayonnement électromagnétique, cette grille étant disposée dans un cadre rectangulaire (23) et étant faite de cellules, caractérisé en ce que la grille est serrée élastiquement au niveau d'au moins deux côtés opposés entre une aile (92) du cadre, qui est de section transversale en L, et des oreilles de support élastiques (31) formées sur un ou plusieurs éléments de montage denticulés (27) fixés au cadre.

2. Panneau de ventilation suivant la revendication 1, caractérisé en ce qu'il comporte un seul élément de montage (27) qui est formé à partir d'une bande de métal par des opérations d'estampage et de pliage.

3. Panneau de ventilation suivant la revendication 1, caractérisé en ce que les oreilles de support (31) de l'élément de montage ou de chaque élément de montage ont une section transversale en V avec une branche (37) qui attaque le cadre et dont la hauteur est supérieure à la hauteur de l'aile correspondante (41) du cadre de section en L auquel le ou les éléments de montage est ou sont fixés.

4. Panneau de ventilation suivant la revendication 1, caractérisé en ce que l'élément de montage ou chaque élément de montage est pourvu d'oreilles (35) au moyen desquelles le ou les éléments de montage peuvent être fixés à une ou plusieurs parois d'une boîte blindée électromagnétiquement.

5. Panneau de ventilation suivant la revendication 1, caractérisé en ce que le ou les éléments de montage (27) est ou sont serrés élastiquement au niveau d'au moins deux côtés opposés du cadre entre deux parois (7, 9) d'une boîte (3) blindée électromagnétiquement comportant des ouvertures de ventilation pour refroidir des panneaux qui portent des composantes électriques et sont fixés dans la boîte.

FIG.1

FIG.2

FIG.3

1

FIG.4

FIG.5

FIG.6

FIG.7

2

# FIG.8

3